# EUROPEAN PATENT APPLICATION

(11) **EP 4 642 188 A1**
(43) Date of publication of application: **29.10.2025**
(21) Application number: 25151805.6
(22) Date of filing: 14.01.2025
(51) Int. Cl.: H10D 84/01, H10D 84/83, H10D 84/85

(54) **SEMICONDUCTOR DEVICE WITH TUNED THRESHOLD VOLTAGES**

(30) Priority: 23.04.2024 KR 20240054149
(71) Applicant: Samsung Electronics Co., Ltd., Suwon-si, Gyeonggi-do 16677 (KR)
(72) Inventor: SONG, Hee Chan, 16677 Suwon-si (KR); KIM, Taekjung, 16677 Suwon-si (KR); LEE, Dongsoo, 16677 Suwon-si (KR)
(74) Representative: Marks & Clerk LLP

(57) **Abstract**

A semiconductor device may include a semiconductor substrate including first (10) and second (20) regions, a first gate structure (GS1) on the first region, and a second gate structure (GS2) on the second region. Each of the first and second gate structures includes a metal pattern, a high-k dielectric pattern between the semiconductor substrate and the metal pattern, and a work-function layer between the high-k dielectric pattern and the metal pattern. The work-function layer (WF1a) of the first gate structure includes a first metal element in the metal pattern (WF1b) of the first gate structure and a dipole material in the high-k dielectric pattern (HK1) of the first gate structure, and the work-function layer (HK2b) and the high-k dielectric pattern (HK2a) in the second gate structure include a metal oxide material. In the second gate structure, an oxygen content in the work-function layer (HK2b) is higher than that in the high-k dielectric pattern (HK2a).

## Description

Various example embodiments relate to a semiconductor device, and in particular, to a semiconductor device including transistors with different threshold voltages.

### BACKGROUND

A semiconductor device includes an integrated circuit including metal-oxide-semiconductor field-effect transistors (MOS-FETs). As an integration density of the semiconductor device increases, the MOS-FETs are being aggressively scaled down, but this leads to deterioration in operational characteristics of the semiconductor device. Thus, a variety of studies are being conducted to overcome technical limitations associated with the scale-down of the semiconductor device and to realize high-performance semiconductor devices.

### SUMMARY

Various example embodiments may provide a semiconductor device having improved electrical characteristics.

According to various example embodiments, a semiconductor device includes a semiconductor substrate including a first region and a second region, a first gate structure on the first region of the semiconductor substrate, and a second gate structure on the second region of the semiconductor substrate. The first gate structure includes a first metal pattern, a first high-k dielectric pattern between the semiconductor substrate and the first metal pattern, and a first work-function layer between the first high-k dielectric pattern and the first metal pattern. The second gate structure includes a second metal pattern, a second high-k dielectric pattern between the semiconductor substrate and the second metal pattern, and a second work-function layer between the second high-k dielectric pattern and the second metal pattern. The first work-function layer includes a first metal element in the first metal pattern and a dipole material in the first high-k dielectric pattern, and the second work-function layer and the second high-k dielectric pattern include a metal oxide material. An oxygen content in the second work-function layer is greater than an oxygen content in the second high-k dielectric pattern.

Alternatively or additionally according to various example embodiments, a semiconductor device includes a semiconductor substrate including a first region and a second region, a first gate structure on the first region of the semiconductor substrate, and a second gate structure on the second region of the semiconductor substrate. The first gate structure may include a first gate electrode, a first interface pattern between the first gate electrode and the semiconductor substrate, a first high-k dielectric pattern between the first interface pattern and the first gate electrode, and a first metal pattern between the first high-k dielectric pattern and the first gate electrode. The second gate structure may include a second gate electrode, a second interface pattern between the second gate electrode and the semiconductor substrate, a second high-k dielectric pattern between the second interface pattern and the second gate electrode, and a second metal pattern between the second high-k dielectric pattern and the second gate electrode. The first and second metal patterns may include a metallic material having the same work-function. The first metal pattern may include a first lower portion in contact with a top surface of the first high-k dielectric pattern and a first upper portion spaced apart from the first high-k dielectric pattern. The second high-k dielectric pattern may include a second lower portion adjacent to the second interface pattern and a second upper portion adjacent to the second metal pattern. The first high-k dielectric pattern and the first lower portion of the first metal pattern may include a lanthanoid material. An oxygen content in the second upper portion of the second high-k dielectric pattern may be greater than an oxygen content in the second lower portion.

Alternatively or additionally according to various example embodiments, a semiconductor device may include a semiconductor substrate including a cell array region and a peripheral region, the peripheral region including a first region and a second region, a device isolation layer defining a cell active region in the cell array region, a first active region in the first region, and a second active region in the second region, a bit line structure provided on the cell array region to cross the cell active region, a first gate structure on the first active region, and a second gate structure on the second active region. The first gate structure may include a first gate electrode, a first interface pattern between the first gate electrode and the semiconductor substrate, a first high-k dielectric pattern between the first interface pattern and the first gate electrode, and a first metal pattern between the first high-k dielectric pattern and the first gate electrode. The second gate structure may include a second gate electrode, a second interface pattern between the second gate electrode and the semiconductor substrate, a second high-k dielectric pattern between the second interface pattern and the second gate electrode, and a second metal pattern between the second high-k dielectric pattern and the second gate electrode. The bit line structure may include a bit line, which is extended in a specific direction, and a bit line contact pattern, which is provided between the bit line and the cell active region. The first high-k dielectric pattern and a lower portion of the first gate electrode contacting the first high-k dielectric pattern, may include a dipole material. The second high-k dielectric pattern may include a lower portion adjacent to the second interface pattern and an upper portion adjacent to the second metal pattern. An oxygen content in the upper portion of the second high-k dielectric pattern may be greater than an oxygen content in the lower portion.

Alternatively or additionally according to various example embodiments, a method of fabricating a semiconductor device may include providing a semiconductor substrate including first and second regions, forming a high-k dielectric layer on the semiconductor substrate, forming a sacrificial metal pattern on the high-k dielectric layer on the second region, forming a dipole layer on the high-k dielectric layer on the first region and the sacrificial metal pattern on the second region, performing a first thermal treatment process to provide a dipole material in the dipole layer into the high-k dielectric layer on the first region and to form a first work-function layer between the sacrificial metal pattern and the high-k dielectric layer, removing the dipole layer and the sacrificial metal pattern, forming a metal layer to cover the high-k dielectric layer on the first region, the metal layer including the dipole material, and performing a second thermal treatment process to form a second work-function layer, which includes the dipole material, on the first region and between the high-k dielectric layer and the metal layer.

At least some of the above and other features of the invention are set out in the claims.

### BRIEF DESCRIPTION OF THE DRAWINGS

FIG. 1 is a plan view illustrating a semiconductor device according to various example embodiments.
FIG. 2 is a sectional view, which is taken along lines A-A' and B-B' of FIG. 1 to illustrate a semiconductor device according to various example embodiments.
FIG. 3A is an enlarged sectional view illustrating a portion 'P1' of FIG. 2.
FIG. 3B is an enlarged sectional view illustrating a portion 'P2' of FIG. 2.
FIG. 4 is a sectional view, which is taken along the lines A-A' and B-B' of FIG. 1 to illustrate a semiconductor device according to various example embodiments.
FIG. 5 is a flow chart illustrating a method of fabricating a semiconductor device according to various example embodiments.
FIGS. 6 to 12 are diagrams illustrating a method of fabricating a semiconductor device, according to various example embodiments.
FIG. 13A is a sectional view, which is taken along the lines A-A' and B-B' of FIG. 1 to illustrate a semiconductor device according to various example embodiments.
FIG. 13B is a sectional view, which is taken along lines C-C' and D-D' of FIG. 1 to illustrate a semiconductor device according to various example embodiments.
FIG. 14A is a sectional view, which is taken along the lines A-A' and B-B' of FIG. 1 to illustrate a semiconductor device according to various example embodiments.
FIG. 14B is a sectional view, which is taken along the lines C-C' and D-D' of FIG. 1 to illustrate a semiconductor device according to various example embodiments.
FIG. 15A is an enlarged sectional view illustrating a portion 'P3' of FIG. 14A.
FIG. 15B is an enlarged sectional view illustrating a portion 'P4' of FIG. 14A.
FIG. 16 is a plan view illustrating a semiconductor device according to various example embodiments.
FIG. 17 is a sectional view, which is taken along lines I-I', II-II', and III-III' of FIG. 16 to illustrate a semiconductor device according to various example embodiments.

### DETAILED DESCRIPTION

Various example embodiments of inventive concepts will now be described more fully with reference to the accompanying drawings, in which example embodiments are shown.

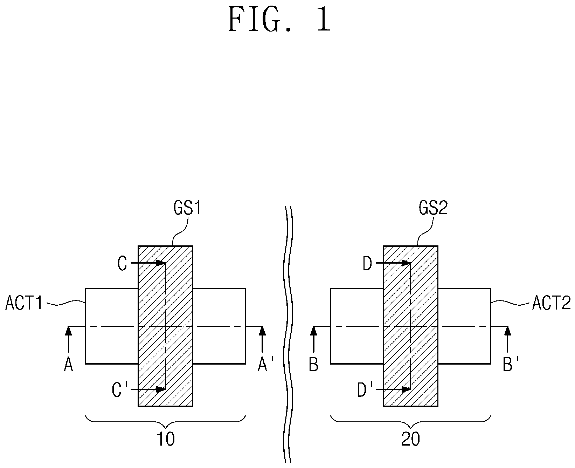

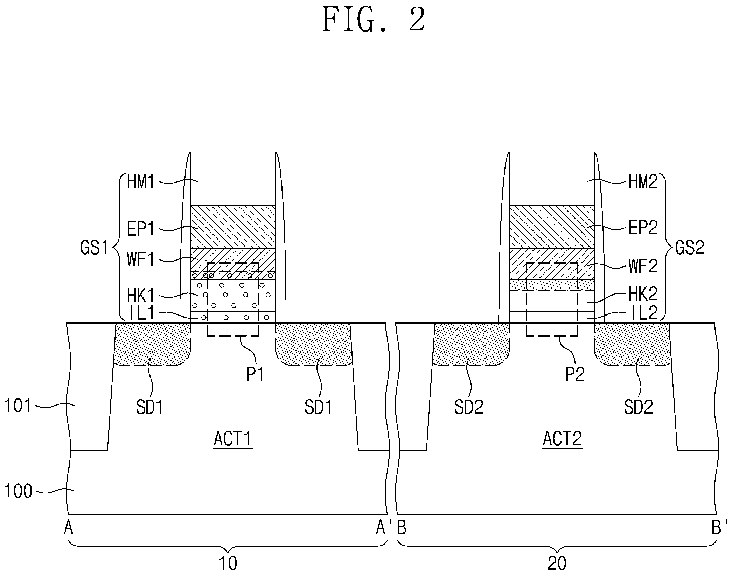

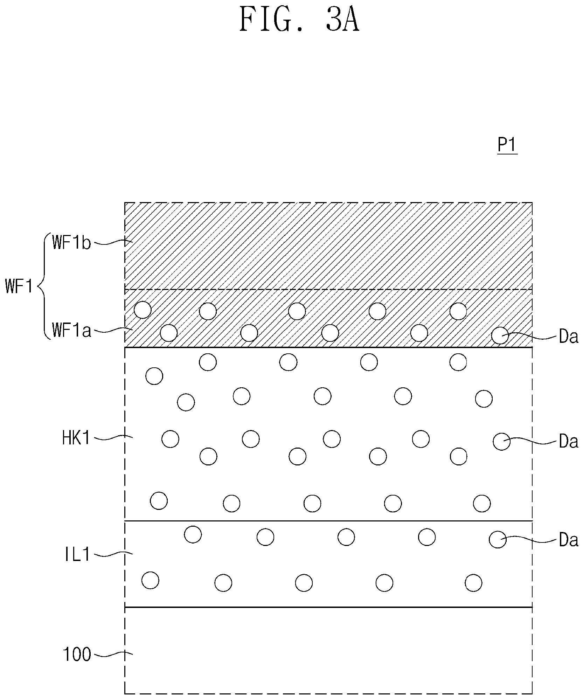

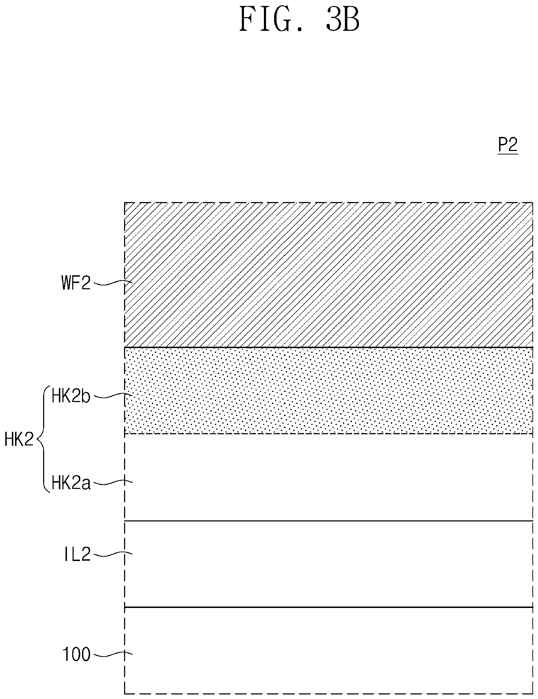

FIG. 1 is a plan view illustrating a semiconductor device according to various example embodiments. FIG. 2 is a sectional view, which is taken along lines A-A' and B-B' of FIG. 1 to illustrate a semiconductor device according to various example embodiments. FIG. 3A is an enlarged sectional view illustrating a portion 'P1' of FIG. 2. FIG. 3B is an enlarged sectional view illustrating a portion 'P2' of FIG. 2.

Referring to FIGS. 1 and 2, a semiconductor substrate 100 including a first region 10 and a second region 20 may be provided.

The semiconductor substrate 100 may be or may include a single crystalline silicon wafer, but in some example embodiments, the semiconductor substrate 100 may be or include one or more of a silicon-on-insulator (SOI) wafer, a germanium wafer, a germanium-on-insulator (GOI) wafer, a silicon-germanium wafer, or a substrate including an epitaxial layer formed by a selective epitaxial growth (SEG) process. In various example embodiments, the semiconductor substrate 100 may include an n- or p-type well impurity layer.

In various example embodiments, a first transistor may be provided on the first region 10, and a second transistor may be provided on the second region 20. The first and second transistors may have threshold voltages that are different from each other. For example, the threshold voltage of the second transistor may be lower than or lower in absolute value than the threshold voltage of the first transistor. In some examples, an NMOS transistor may be provided on the first region 10, and a PMOS transistor may be provided on the second region 20.

In more detail, a device isolation layer 101 may be disposed in the semiconductor substrate 100 to define a first active region ACT1 on the first region 10 of the semiconductor substrate 100 and a second active region ACT2 on the second region 20 of the semiconductor substrate 100.

A first gate structure GS1 is be provided on the first active region ACT1, and first source/drain regions SD1 may be provided in the semiconductor substrate 100 disposed at both sides of the first gate structure GS1. The first source/drain regions SD1 may be portions of the semiconductor substrate 100 that are doped with impurities of a first conductivity type (e.g., n-type), such as phosphorus and/or arsenic.

A second gate structure GS2 is be disposed on the second active region ACT2 and on the semiconductor substrate 100, and second source/drain regions SD2 may be provided in the semiconductor substrate 100 at both sides of the second gate structure GS2. The second source/drain regions SD2 may be portions of the semiconductor substrate 100 that are doped with impurities of a second conductivity type (e.g., p-type), such as boron.

In various example embodiments, the first gate structure GS1 may include a first interface pattern IL1, a first high-k dielectric pattern HK1, a first metal pattern WF1, a first gate electrode EP1, and a first hard mask pattern HM1.

In detail, the first interface pattern IL1 may be disposed between the first high-k dielectric pattern HK1 and the semiconductor substrate 100. The first interface pattern IL1 may include at least one of silicon oxide, silicon oxynitride, or silicon nitride. Furthermore, referring to FIG. 3A, the first interface pattern IL1 may include a dipole material Da, which may be used to adjust a threshold voltage of the first transistor, e.g., to increase or decrease the threshold voltage of the first transistor.

The first high-k dielectric pattern HK1 may be disposed between the first interface pattern IL1 and the first metal pattern WF1. The first high-k dielectric pattern HK1 may be formed of a high-k dielectric material whose dielectric constant is higher than that of silicon oxide. The first high-k dielectric pattern HK1 may include at least one of metal oxides, metal silicates, or metal silicate nitrides. As used herein, "high-k dielectric" refers to material having a dielectric constant greater than that of silicon oxide (SiO₂).

The first high-k dielectric pattern HK1 may include oxides containing metallic elements (e.g., one or more of hafnium (Hf), aluminum (Al), lanthanum (La), and zirconium (Zr)). The first high-k dielectric pattern HK1 may include hafnium silicate (HfSiO), zirconium silicate (ZrSiO), or combinations thereof. In various example embodiments, the first high-k dielectric pattern HK1 may include hafnium silicate nitride (HfSiON), zirconium silicate nitride (ZrSiON), or combinations thereof.

Referring to FIG. 3A, the first high-k dielectric pattern HK1 may include the dipole material Da, which is used to adjust the threshold voltage of the first transistor, e.g., to increase or decrease the threshold voltage of the first transistor, e.g., without a corresponding change in dopants in an active area of the first transistor. The dipole material Da may include an n- or p-type dipole material. The dipole material Da may include, for example, hafnium (Hf), aluminum (Al), lanthanum (La), zirconium (Zr), yttrium (Y), magnesium (Mg), or combinations thereof. In various example embodiments, the dipole material may be an n-type dipole material (e.g., lanthanum (La)). As an example, the first high-k dielectric pattern HK1 may include LaHfSiON.

The first metal pattern WF1 may be disposed between the first high-k dielectric pattern HK1 and the first gate electrode EP1. The first metal pattern WF1 may be formed of a conductive material having a specific work-function. The first metal pattern WF1 may include a metallic material having a work-function of about 4.7eV to about 5.2 eV. The first metal pattern WF1 may be formed of at least one of metal nitrides (e.g., one or more of titanium nitride, tantalum nitride, tungsten nitride, hafnium nitride, and zirconium nitride)

Referring to FIG. 3A, the first metal pattern WF1 may include a first lower portion WF1a, which is in contact with a top surface of the first high-k dielectric pattern HK1, and a first upper portion WF1b, which is spaced apart from the first high-k dielectric pattern HK1. The first lower portion WF1a of the first metal pattern WF1 includes the dipole material Da, which is used to adjust the threshold voltage of the first transistor. In some example embodiments, the first lower portion WF1a of the first metal pattern WF1 may be referred to as "first work-function layer".

In various example embodiments, the dipole material Da in the first lower portion WF1a of the first metal pattern WF1 may be the same material as the dipole material Da in the first high-k dielectric pattern HK1. For example, the first lower portion WF1a of the first metal pattern WF1 may include an n-type dipole material Da, which contains a lanthanoid (e.g., lanthanum (La)), and in some cases may be diffused from the first high-k dielectric pattern HK1. The first lower portion WF1a of the first metal pattern WF1 may be a thickness range of about 1 Å to 20 Å. The first lower portion WF1a of the first metal pattern WF1 may include La, Hf, Ti, N, O, Si, and so forth. In various example embodiments, the first lower portion WF1a of the first metal pattern WF1 may include LaTiN, and the first upper portion WF1b may include TiN.

The dipole material Da, which is present in the first interface pattern IL1, the first high-k dielectric pattern HK1, and the first lower portion WF1a of the first metal pattern WF1, may form a dipole at an interface between the first high-k dielectric pattern HK1 and the first interface pattern IL1, and this dipole may make it possible to change an effective work-function of the first transistor and to modulate (increase or decrease in absolute value) the threshold voltage of the first transistor.

The first gate electrode EP1 may be disposed between the first metal pattern WF1 and the first hard mask pattern HM1. The first gate electrode EP1 may be formed of one or more of materials having an electric resistivity lower than that of the first metal pattern WF1. The first gate electrode EP1 may be formed of at least one of tungsten, copper, hafnium, zirconium, titanium, tantalum, aluminum, ruthenium, palladium, platinum, cobalt, nickel, or conductive metal nitrides.

The first hard mask pattern HM1 on the first gate electrode EP1 may include silicon nitride.

In various example embodiments, the second gate structure GS2 may include a second interface pattern IL2, a second high-k dielectric pattern HK2, a second metal pattern WF2, a second gate electrode EP2, and a second hard mask pattern HM2.

The second interface pattern IL2 may be disposed between the semiconductor substrate 100 and the second high-k dielectric pattern HK2. The second interface pattern IL2 may include, for example, silicon oxide, silicon oxynitride, silicon nitride, or combinations thereof. The second interface pattern IL2 may have substantially the same thickness as the first interface pattern IL1. The second interface pattern IL2 may be formed of the same insulating material as the first interface pattern IL1 but need not include the dipole material Da in the first interface pattern IL1.

The second high-k dielectric pattern HK2 may be disposed between the second interface pattern IL2 and the second metal pattern WF2. The second high-k dielectric pattern HK2 may be formed of a high-k dielectric material whose dielectric constant is higher than that of silicon oxide. The second high-k dielectric pattern HK2 may include at least one of metal oxides, metal silicates, or metal silicate nitrides.

The second high-k dielectric pattern HK2 may have substantially the same thickness as the first high-k dielectric pattern HK1 and may contain the same metal element as the first high-k dielectric pattern HK1. Referring to FIG. 3B, the second high-k dielectric pattern HK2 may include a second lower portion HK2a adjacent to the second interface pattern IL2 and a second upper portion HK2b adjacent to the second metal pattern WF2. The second high-k dielectric pattern HK2 may be formed of at least one of metal oxides, and an oxygen content of the second upper portion HK2b may be higher than that of the second lower portion HK2a. The second high-k dielectric pattern HK2 having a high oxygen content may be used to adjust the threshold voltage of the second transistor. In some example embodiments, the second upper portion HK2b of the second high-k dielectric pattern HK2 may be referred to as a "second work-function layer". In various example embodiments, the term "oxygen content" may mean or indicate the number of oxygen atoms per unit volume.

The second lower portion HK2a of the second high-k dielectric pattern HK2 may include HfSiON, and the second upper portion HK2b may include oxygen-rich TiHfSiON or TiHfON. The second upper portion HK2b may have a thickness ranging from about 1 Å to about 20 Å. A thickness of the first high-k dielectric pattern HK1 may be the same as, greater than, or less than a thickness of the second high-k dielectric pattern HK2.

The second metal pattern WF2 may be disposed between the second high-k dielectric pattern HK2 and the second gate electrode EP2. The second metal pattern WF2 may be formed of a metallic material having the same work-function as the metallic material of the first metal pattern WF1. The second metal pattern WF2 may include a metallic material having a work-function of about 4.7eV to about 5.2 eV. In various example embodiments, the second metal pattern WF2 may be formed of at least one of metal nitrides (e.g., titanium nitride, tantalum nitride, tungsten nitride, hafnium nitride, and zirconium nitride). In some examples, the second metal pattern WF2 may include TiHfON. The second metal pattern WF2 may have substantially the same thickness as the first metal pattern WF1.

The second gate electrode EP2 may be disposed between the second metal pattern WF2 and the second hard mask pattern HM2. In various example embodiments, the second gate electrode EP2 may be formed of at least one of tungsten, copper, hafnium, zirconium, titanium, tantalum, aluminum, ruthenium, palladium, platinum, cobalt, nickel, or conductive metal nitrides. The second gate electrode EP2 may include the same metallic material as the first gate electrode EP1 and may have substantially the same thickness as the first gate electrode EP1.

The second hard mask pattern HM2 on the second gate electrode EP2 may include silicon nitride.

In the first and second gate structures GS1 and GS2, a distance from a top surface of the semiconductor substrate 100 to the first work-function layer WF1a may be substantially equal to a distance from the top surface of the semiconductor substrate 100 to the second work-function layer HK2b. Alternatively, the distance from the top surface of the semiconductor substrate 100 to the first work-function layer WF1a may be larger than or smaller than the distance from the top surface of the semiconductor substrate 100 to the second work-function layer HK2b.

According to various example embodiments, in the second gate structure GS2, the second interface pattern IL2, the second high-k dielectric pattern HK2, and the second metal pattern WF2 does not include an n-type dipole material. Thus, on the second region 20, it may be possible to prevent or reduce the likelihood of and/or impact from the dipole material from entering an interface between the semiconductor substrate 100 and the second gate structure GS2 and from deteriorating the characteristics of the second transistor.

Alternatively or additionally, since the first and second gate structures GS1 and GS2 have substantially the same height and the first and second metal patterns WF1 and WF2 include the same metallic material, it may be possible to facilitate the process of fabricating the semiconductor device.

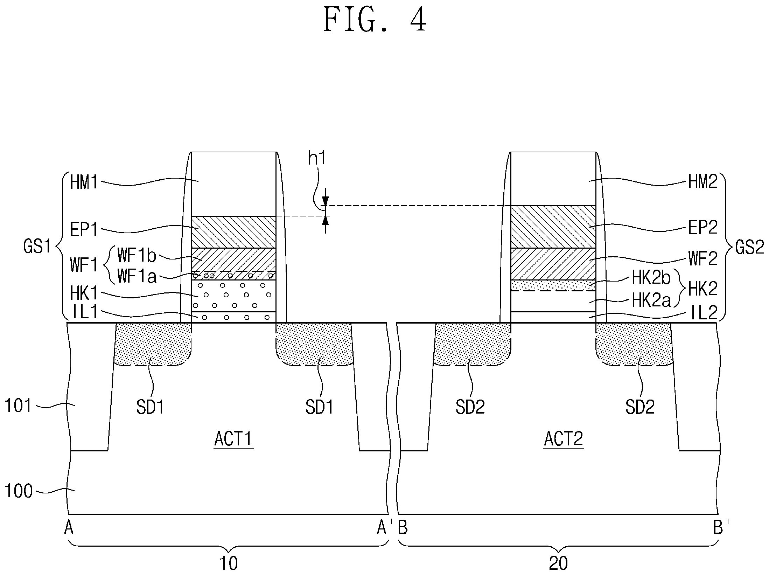

FIG. 4 is a sectional view, which is taken along the lines A-A' and B-B' of FIG. 1 to illustrate a semiconductor device according to various example embodiments. For concise description, a previously described element may be identified by the same reference number without repeating an overlapping description thereof.

In example embodiments illustrated in FIG. 4, the first gate structure GS1 may include the first interface pattern IL1, the first high-k dielectric pattern HK1, the first work-function layer WF1a, the first metal pattern WF1b, the first gate electrode EP1, and the first hard mask pattern HM1 sequentially stacked, as described above.

The second gate structure GS2 may include the second interface pattern IL2, the second high-k dielectric pattern HK2b, the second work-function layer HK2b, the second metal pattern WF2, the second gate electrode EP2, and the second hard mask pattern HM2 sequentially stacked.

In the first and second gate structures GS1 and GS2, the first interface pattern IL1 and the first high-k dielectric pattern HK1 may include the dipole material Da (see Fig. 3A), and the second interface pattern IL2 and the second high-k dielectric pattern HK2 need not include the dipole material. The first gate structure GS1 includes the first work-function layer WF1a, and the second gate structure GS2 includes the second work-function layer HK2b. The first work-function layer WF1a may be disposed between the first high-k dielectric pattern HK1 and the first metal pattern WF1 and may include the dipole material Da. The second work-function layer HK2b may be disposed between the second high-k dielectric pattern HK2 and the second metal pattern WF2 and has an oxygen content that is higher than that in the lower portion HK2a of the second high-k dielectric pattern HK2.

The first metal pattern WF1b of the first gate structure GS1 may include the same metallic material as the second metal pattern WF2. A thickness of the first metal pattern WF1 may be different from (greater than or less than) a thickness of the second metal pattern WF2. In various example embodiments, a top surface of the second metal pattern WF2 may be located at a level higher than a top surface of the first metal pattern WF1. For example, the thickness of the first metal pattern WF1 of the first gate structure GS1 may be smaller than the thickness of the second metal pattern WF2 of the second gate structure GS2. A height difference h1 between the top surface of the first metal pattern WF1 and the top surface of the second metal pattern WF2 may range from about 1 Å to 20 Å.

The first work-function layer WF1a may include a first metal element and a lanthanoid material, and the second work-function layer HK2b may include a second metal element and oxygen. Here, the second metal element may be different from the first metal element.

The second gate electrode EP2 may include the same metallic material as the first gate electrode EP1 and may have substantially the same thickness as the first gate electrode EP1.

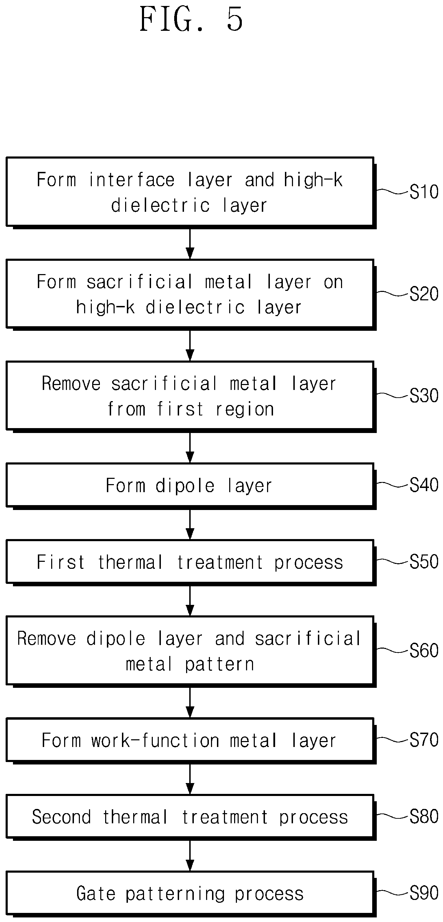

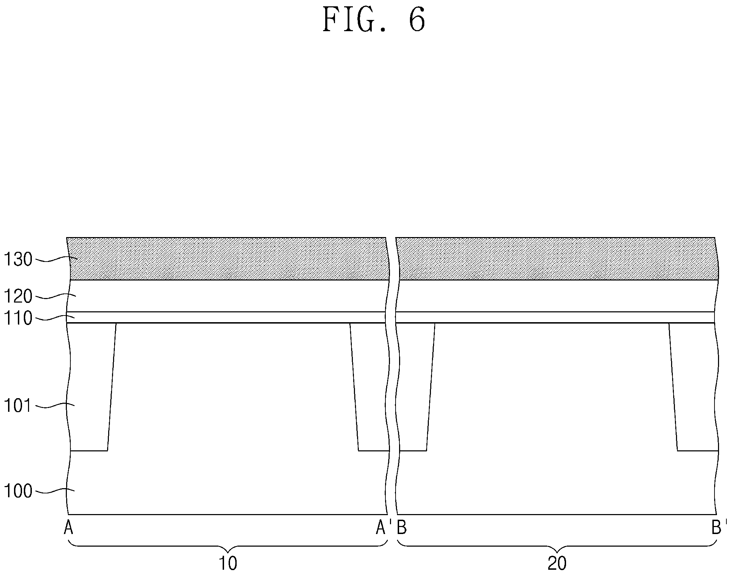

FIG. 5 is a flow chart illustrating a method of fabricating a semiconductor device according to various example embodiments. FIGS. 6 to 12 are diagrams illustrating a method of fabricating a semiconductor device, according to various example embodiments.

Referring to FIGS. 5 and 6, the semiconductor substrate 100 including the first and second regions 10 and 20 may be provided.

In various example embodiments, the semiconductor substrate 100 may be or include a single crystalline silicon wafer, but some example embodiments, the semiconductor substrate 100 may be or include a silicon-on-insulator (SOI) wafer, a germanium wafer, a germanium-on-insulator (GOI) wafer, a silicon-germanium wafer, or a substrate including an epitaxial layer formed by a selective epitaxial growth (SEG) process. In various example embodiments, the semiconductor substrate 100 may include an n- or p-type well impurity layer; example embodiments are not limited thereto.

A first transistor having a first threshold voltage may be formed on the first region 10, and a second transistor having a second threshold voltage, which is lower than the first threshold voltage, may be formed on the second region 20. In some example embodiments, the first transistor may be a PMOS transistor and the second transistor may be an NMOS transistor; however, example embodiments are not limited thereto. For example, in some example embodiments both the first transistor and the second transistor may be PMOS transistors, or both the first transistor and the second transistor may be NMOS transistors.

The device isolation layer 101 may be formed to define the first active region ACT1 and the second active region ACT2 in the semiconductor substrate 100.

The formation of the device isolation layer 101 may include patterning the semiconductor substrate 100 to form trenches, depositing an insulating layer to fill the trenches, and then, planarizing the insulating layer to expose the top surface of the semiconductor substrate 100.

In various example embodiments, a top surface of the device isolation layer 101 may be recessed to a level lower than the top surface of the semiconductor substrate 100, and the semiconductor substrate 100 may include fin-shaped active patterns that protrude to a level higher than the top surface of the device isolation layer 101.

Next, an interface layer 110 and a high-k dielectric layer 120 may be sequentially formed on the semiconductor substrate 100 (in S10).

The interface layer 110 may be formed of an insulating material whose dielectric constant is less than 9. For example, the interface layer 110 may include a silicon oxide layer and/or a silicon oxynitride layer. The interface layer 110 may be formed by one or more of a thermal oxidation method, an atomic layer deposition (ALD) method, or a chemical vapor deposition (CVD) method. The interface layer 110 may improve the interfacial characteristics between the semiconductor substrate 100 and the high-k dielectric layer 120, and thus, the electron mobility characteristics of the semiconductor device may be improved.

The high-k dielectric layer 120 may be formed of a high-k dielectric material, whose dielectric constant is greater than that of silicon oxide, and may be thicker than the interface layer 110. In various example embodiments, the lower high-k dielectric layer 120 may include at least one of metal oxides, metal silicates, or metal silicate nitrides.

The metal oxides may include oxides containing a metal element (e.g., one or more of hafnium (Hf), aluminum (Al), lanthanum (La), and zirconium (Zr)). For example, the metal oxides may include hafnium oxide, aluminum oxide, lanthanum oxide, zirconium oxide, or combinations thereof. For example, the metal oxide material may include HfO₂, Al₂O₃, La₂O₃, ZrO₂, or combinations thereof.

The metal silicates may include silicates containing a metal element (e.g., hafnium (Hf) and zirconium (Zr)). For example, the metal silicates may include hafnium silicate (HfSiO), zirconium silicate (ZrSiO), or combinations thereof.

The metal silicate nitrides may include silicate nitrides containing a metal element (e.g., hafnium (Hf) and zirconium (Zr)). In various example embodiments, the metal silicate nitrides may include hafnium silicon nitride (HfSiON), zirconium silicate nitride (ZrSiON), or combinations thereof.

In various example embodiments, the high-k dielectric layer 120 may be formed by one or more of a chemical vapor deposition (CVD) method, a Low-Pressure CVD (LPCVD) method, a plasma-enhanced CVD (PECVD) method, a metal-organic CVD (MOCVD) method, an atomic layer deposition (ALD) method, or a plasma-enhanced ALD (PEALD) method. In some example embodiments, the ALD or PEALD process may be used to improve uniformity of the high-k dielectric layer 120.

A sacrificial metal layer 130 may be formed on the first and second regions 10 and 20 to cover the high-k dielectric layer 120 (in S20).

The sacrificial metal layer 130 may be formed of a conductive material having a specific work-function. In various example embodiments, the sacrificial metal layer 130 may be used to determine work-functions of n-type or p-type transistors. In various example embodiments, the sacrificial metal layer 130 may include a metallic material having the work-function of about 4.7eV to about 5.2eV.

The sacrificial metal layer 130 may include at least one of metal nitrides, metal oxynitrides, metal oxycarbide materials, or metal oxynitride carbide materials. In various example embodiments, the sacrificial metal layer 130 may include a p-type work-function metal. The sacrificial metal layer 130 may be formed of at least one of metal nitrides (e.g., one or more of titanium nitride, tantalum nitride, tungsten nitride, hafnium nitride, and zirconium nitride).

The sacrificial metal layer 130 may include a first metal nitride layer, a work-function adjusting layer, and a second metal nitride layer, which are sequentially stacked.

In various example embodiments, the sacrificial metal layer 130 may be formed of an aluminum-containing conductive material. For example, the sacrificial metal layer 130 may be formed of at least one of metal aluminide, metal aluminum carbide, metal aluminum nitride, or metal aluminum silicide.

The sacrificial metal layer 130 may include a TiN layer or layers of TiN/TaN, Al₂O₃/TiN, Al/TiN, TiN/Al/TiN, TiN/TiON, Ta/TiN, or TaN/TiN, and here, the TiN layer may be replaced with a layer of TaN, TaCN, TiCN, CoN, or CoCN. The sacrificial metal layer 130 may have a thickness ranging from about 10 Å to about 60 Å.

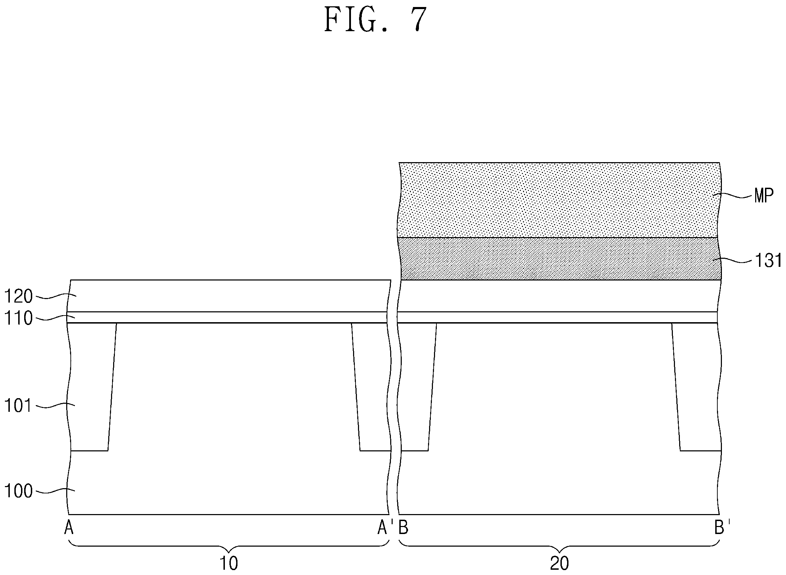

Referring to FIGS. 5 and 7, the sacrificial metal layer 130 may be removed from, e.g., etched from, the first region 10 (in S30). Thus, a top surface of the high-k dielectric layer 120 on the first region 10 may be exposed to the outside, and a sacrificial metal pattern 131 may be formed on the second region 20.

In detail, after forming a mask pattern MP on the second region 20 to cover the sacrificial metal layer 130, the sacrificial metal layer 130 on the first region 10 may be etched, with a wet etch and/or a dry etch, using the mask pattern MP as an etch mask to expose a top surface of the high-k dielectric layer 120 on the first region 10, and to leave the sacrificial layer 131 on the second region 20.

The mask pattern MP may be removed after the high-k dielectric layer 120 is exposed on the first region 10.

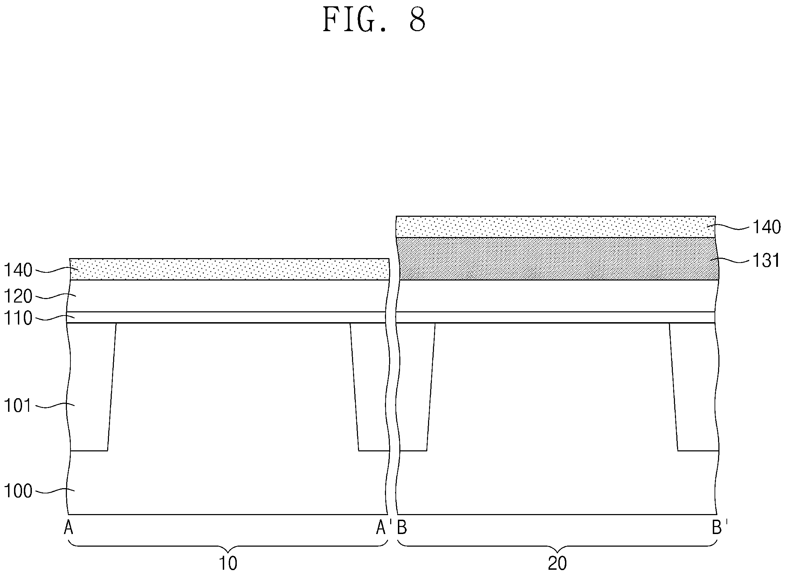

Referring to FIGS. 5 and 8, a dipole layer or a work-function adjusting layer 140 may be formed to cover the high-k dielectric layer 120 on the first region 10 and the sacrificial metal pattern 131 on the second region 20 (in S40).

The dipole layer 140 may include an n- or p-type dipole material. The dipole material may be a metallic material having a higher electron affinity than the metallic material in the high-k dielectric layer 120. For example, the dipole material may include at least one of Al, Mg, Ca, Sr, V, Nb, Sc, Y, or lanthanoid materials. In various example embodiments, the dipole layer 140 may include at least one, which is selected from lanthanum (La), lanthanum oxide (LaO), tantalum (Ta), tantalum nitride (TaN), niobium (Nb), or titanium nitride (TiN). In the case where the first region 10 is an NMOS transistor region, the dipole layer 140 may be a lanthanum oxide layer.

The dipole layer 140 may be formed using a chemical vapor deposition method and/or an atomic layer deposition method.

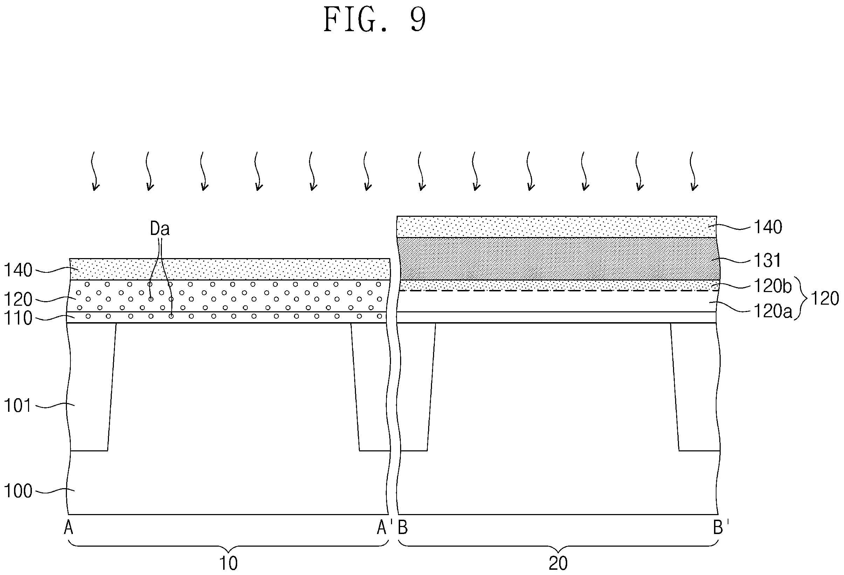

Referring to FIGS. 5 and 9, a first thermal treatment process may be performed (in S50), after the formation of the dipole layer 140.

The first thermal treatment process may include performing an annealing process within a first temperature range. The annealing process may be or may include one or more of a furnace annealing, a rapid thermal annealing, or a laser annealing. The first temperature range in the first thermal treatment process may be determined in consideration of a threshold voltage of the transistor on the first region 10. In some example embodiments, the first thermal treatment process may be performed at temperature of about 50°C to 1400°C, using an oxygen gas or a nitrogen gas.

As a result of the first thermal treatment process, the dipole material in the dipole layer 140 on the first region 10 may be diffused into the interface layer 110 and the high-k dielectric layer 120. In the first region 10, the dipole material diffused into the high-k dielectric layer 120 may form dipoles at an interface between the interface layer 110 and the high-k dielectric layer 120. Due to the presence of such dipoles, the threshold voltage of the transistor may be changed.

After the first thermal treatment process, the concentrations of the dipole material in the interface layer 110 and the high-k dielectric layer 120 may differ between the first region 10 and the second region 20. In some example embodiments, the interface layer 110 and the high-k dielectric layer 120 on the first region 10 may include the dipole material, and the interface layer 110 and the high-k dielectric layer 120 on the second region 20 may not include the dipole material.

Furthermore, in various example embodiments, the sacrificial metal pattern 131 on the second region 20 may prevent or reduce the likelihood of the dipole material in the dipole layer 140 from entering the interface layer 110 and the high-k dielectric layer 120 on the second region 20, during the first thermal treatment process.

Alternatively or additionally, since the first thermal treatment process is performed using the oxygen gas, the oxygen atoms may penetrate the sacrificial metal pattern 131 on the second region 20, and in this case, an upper portion 120b of the high-k dielectric layer 120 in contact with the sacrificial metal pattern 131 has an oxygen concentration that is higher than with that of a lower portion 120a. For example, after the first thermal treatment process, the high-k dielectric layer 120 on the second region 20 may be formed of metal oxide layers with different oxygen contents, and a second work-function layer 120b having a high oxygen content may be formed on the second region 20 and between the sacrificial metal pattern 131 and the lower portion 120a of the high-k dielectric layer 120.

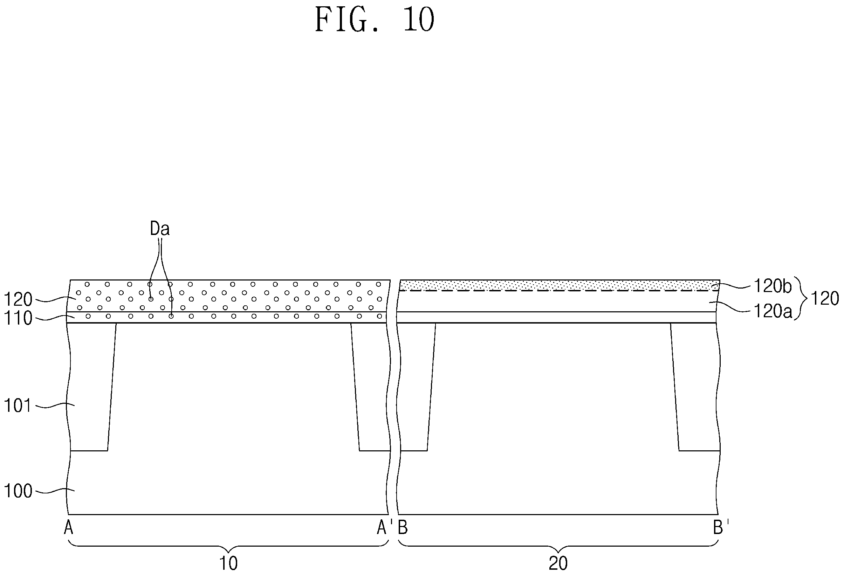

Referring to FIGS. 5 and 10, a process, such as one or more of an etching process or a chemical mechanical planarization process, may be performed to sequentially remove the dipole layer 140 and the sacrificial metal pattern 131 (in S60), after the first thermal treatment process. Thus, the top surface of the high-k dielectric layer 120 may be exposed on the first and second regions 10 and 20.

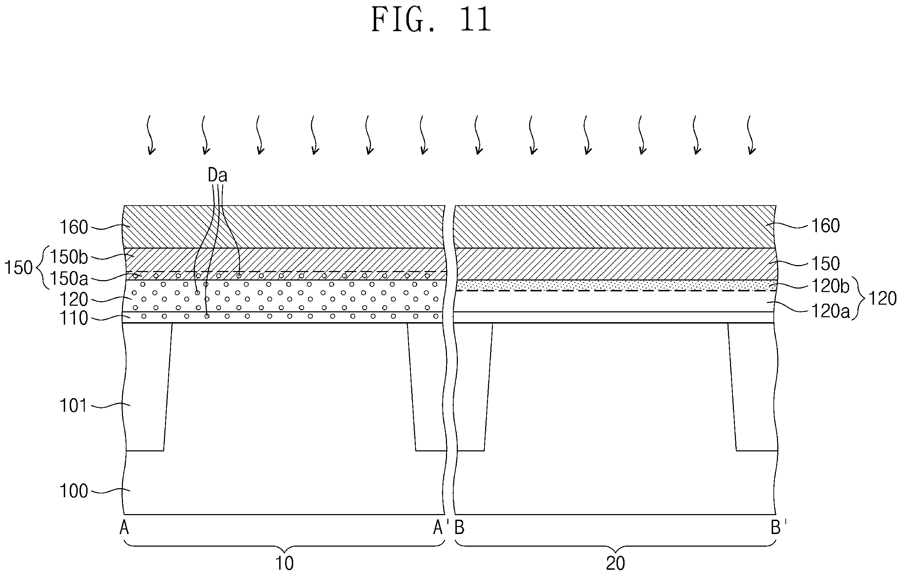

Referring to FIGS. 5 and 11, a work-function metal layer 150 may be formed on the first and second regions 10 and 20 to cover the high-k dielectric layer 120 (in S70).

The work-function metal layer 150 may include Ti, N, O, Al, W, Mo, or La. The work-function metal layer 150 may be formed of at least one of metal nitrides (e.g., titanium nitride, tantalum nitride, tungsten nitride, hafnium nitride, and zirconium nitride). For example, the work-function metal layer 150 may be formed of a titanium nitride layer (TiN) or a tantalum nitride layer (TaN).

Next, a gate metal layer 160 may be formed on the work-function metal layer 150. The gate metal layer 160 may be formed of one of materials whose resistivity is lower than that of the work-function metal layer 150. For example, the gate metal layer 160 may be formed of at least one of tungsten, copper, hafnium, zirconium, titanium, tantalum, aluminum, ruthenium, palladium, platinum, cobalt, nickel, or conductive metal nitrides.

Referring to FIGS. 5 and 11, a second thermal treatment process may be performed (in S80), after the formation of the gate metal layer 160. The second thermal treatment may include one or more of a furnace anneal, a rapid thermal anneal, or a laser anneal; example embodiments are not limited thereto.

The second thermal treatment process may include performing an annealing process within a second temperature range. Here, the second temperature range may be higher than the first temperature range in the first thermal treatment process. For example, the second thermal treatment process using nitrogen gas or oxygen gas may be performed at a temperature of about 50°C to 1400°C.

In various example embodiments, the second thermal treatment process may include an annealing process for the activation of the source/drain regions.

During the second thermal treatment process, the dipole material in the high-k dielectric layer 120 on the first region 10 may be diffused into a lower portion of the work-function metal layer 150. Thus, the work-function metal layer 150 on the first region 10 may include a first work-function layer 150a containing the dipole material.

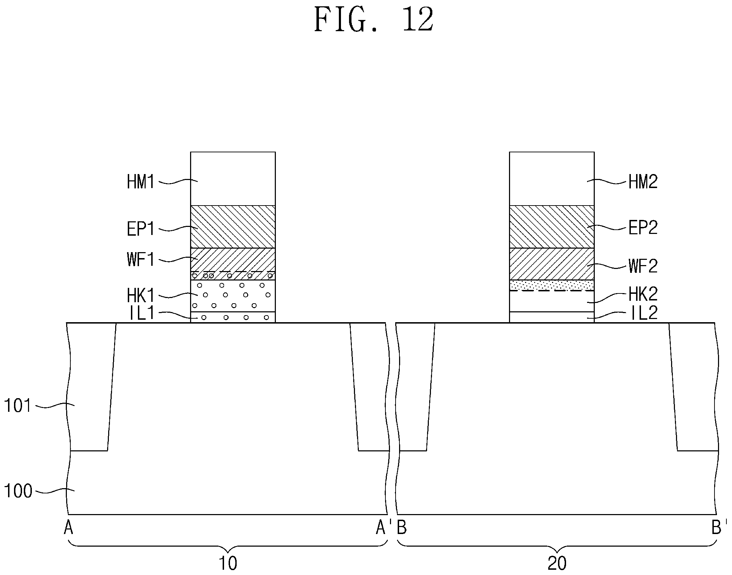

Referring to FIGS. 5 and 12, a gate patterning process may be performed (in S90).

In detail, the first and second hard mask patterns HM1 and HM2 may be formed on the gate metal layer 160.

The first gate structure GS1, in which the first interface pattern IL1, the first high-k dielectric pattern HK1, the first work-function metal pattern WF1, the first gate electrode EP1, and the first hard mask pattern HM1 are sequentially stacked on the first region 10, may be formed by sequentially etching the gate metal layer 160, the work-function metal layer 150, the high-k dielectric layer 120, and the interface layer 110 using the first hard mask patterns HM1.

The second gate structure GS2, in which the second interface pattern IL2, the second high-k dielectric pattern HK2, the second work-function metal pattern WF2, the second gate electrode EP2, and the second hard mask pattern HM2 are sequentially stacked on the second region 20, may be formed by sequentially etching the gate metal layer 160, the work-function metal layer 150, the high-k dielectric layer 120, and the interface layer 110 using the second hard mask patterns HM2.

Next, gate spacers may be formed on opposite side surfaces of the first and second gate structures GS1 and GS2, and then, the first source/drain regions SD1 may be formed in the first region 10 of the semiconductor substrate 100 disposed at both sides of the first gate structure GS1. The first source/drain regions SD1 may be highly doped and in some cases may be formed with an ion implantation process. Furthermore, the second source/drain regions SD2 may be formed in the second region 20 of the semiconductor substrate 100 disposed at both sides of the second gate structure GS2. The second source/drain regions SD2 may be highly doped and in some cases may be formed with an ion implantation process.

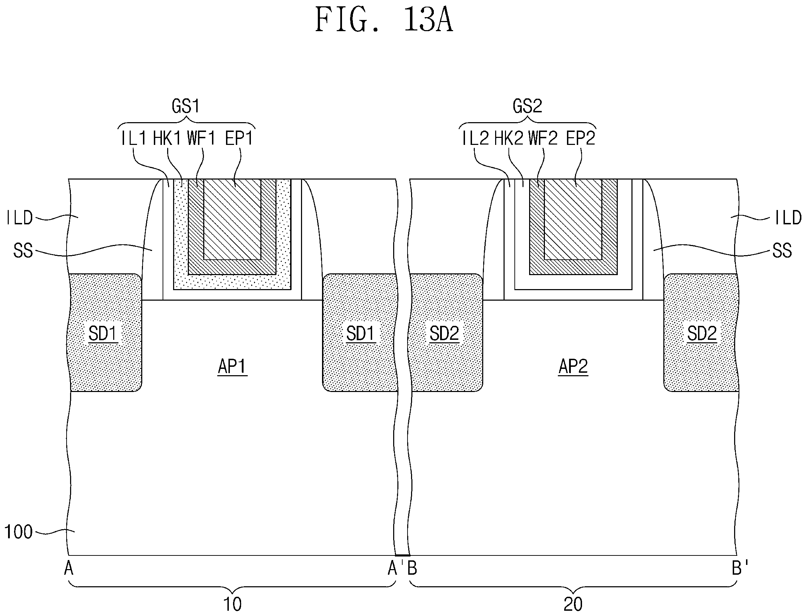

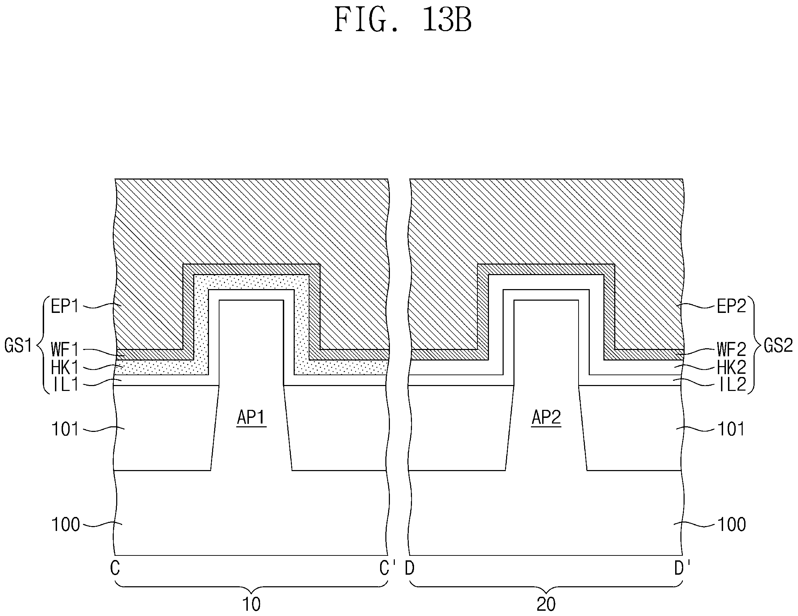

FIG. 13A is a sectional view, which is taken along the lines A-A' and B-B' of FIG. 1 to illustrate a semiconductor device according to various example embodiments. FIG. 13B is a sectional view, which is taken along lines C-C' and D-D' of FIG. 1 to illustrate a semiconductor device according to various example embodiments. For concise description, a previously described element may be identified by the same reference number without repeating an overlapping description thereof.

Referring to FIGS. 13A and 13B, the semiconductor substrate 100 may include a first fin active pattern AP1 in the first region 10 and a second fin active pattern AP2 in the second region 20. The first and second fin active patterns AP1 and AP2 may be portions of the semiconductor substrate 100 or may be epitaxial patterns which are grown from the semiconductor substrate 100.

The first and second gate structures GS1 and GS2 may be disposed to cross the first and second fin active patterns AP1 and AP2, respectively. Each of the first and second fin active patterns AP1 and AP2 is illustrated as a single pattern, but the inventive concept is not limited to this example; for example, a plurality of first fin active patterns AP1 and a plurality of second fin active patterns AP2 may be provided.

The device isolation layer 101 may be provided to define the first and second fin active patterns AP1 and AP2, and a top surface of the device isolation layer 101 may be located at a level lower than top surfaces of the first and second fin active patterns AP1 and AP2.

The first source/drain region SD1 may be disposed on the first fin active pattern AP1 disposed at both sides of the first gate structure GS1, and the second source/drain region SD2 may be disposed on the second fin active pattern AP2 disposed at both sides of the second gate structure GS2.

The first and second source/drain regions SD1 and SD2 may be formed of epitaxial patterns. In some example embodiments, there may be an interface between the source/drain regions and the fin active patterns. The first source/drain region SD1 may be formed of a material capable of exerting a tensile strain on the channel region. For example, the first source/drain region SD1 may be formed of silicon carbide (SiC). The second source/drain region SD2 may be formed of a material capable of exerting a compressive strain on the channel region. For example, the second source/drain region SD2 may be formed of silicon germanium (SiGe). Example embodiments are not limited thereto. For example, in some cases both the first and second source/drain regions SD1 and SD2 may be formed of tensile material, or both may be formed of compressive material.

The first gate structure GS1 may include the first interface pattern IL1, the first high-k dielectric pattern HK1, the first metal pattern WF1, and the first gate electrode EP1. The second gate structure GS2 may include the second interface pattern IL2, the second high-k dielectric pattern HK2, the second metal pattern WF2, the second gate electrode EP2, and the second hard mask pattern HM2.

Spacers SS may be disposed on opposite side surfaces of each of the first and second gate structures GS1 and GS2.

The first high-k dielectric pattern HK1 of the first gate structure GS1 may be extended from a region between a bottom surface of the first gate electrode EP1 and the first interface pattern IL1 to regions between side surfaces of the first gate electrode EP1 and the spacers SS. The first metal pattern WF1 of the first gate structure GS1 may be extended from a region between the bottom surface of the first gate electrode EP1 and the first high-k dielectric pattern HK1 to regions between the side surfaces of the first gate electrode EP1 and the spacers SS. The first interface pattern IL1, the first high-k dielectric pattern HK1, and the first metal pattern WF1 may be provided to substantially have the shape of the letter 'U', and the first gate electrodes EP1 may be provided to fill a gap region, which is defined by the first metal pattern WF1 between the spacers SS. As described above, in the first gate structure GS1, the first interface pattern IL1, the first high-k dielectric pattern HK1, and the lower portion of the first metal pattern WF1 may contain the dipole material.

Similarly, the second high-k dielectric pattern HK2 of the second gate structure GS2 may be extended from a region between a bottom surface of the second gate electrode EP2 and the second interface pattern IL2 to regions between side surfaces of the second gate electrode EP2 and the spacers SS. The second metal pattern WF2 of the second gate structure GS2 may be extended from a region between the bottom surface of the second gate electrode EP2 and the second high-k dielectric pattern HK2 to regions between the side surfaces of the second gate electrode EP2 and the spacers SS. The second interface pattern IL2, the second high-k dielectric pattern HK2, and the second metal pattern WF2 may be provided to substantially have the shape of the letter 'U', and the second gate electrodes EP2 may be provided to fill a gap region, which is defined by the second metal pattern WF2 between the spacers SS. As described above, in the second gate structure GS2, the second high-k dielectric pattern HK2 may include a metal element and oxygen, and an oxygen content of an upper portion adjacent to the second metal pattern WF2 may be higher than an oxygen content of a lower portion adjacent to the second interface pattern IL2.

An interlayer insulating layer ILD may be disposed to cover the device isolation layer 101 and the first and second source/drain regions SD1 and SD2. The interlayer insulating layer ILD may be substantially coplanar with top surfaces of the first and second gate structures GS1 and GS2. In various example embodiments, the interlayer insulating layer ILD may include at least one of oxides, nitrides, or oxynitrides and may include at least one of low-k dielectric materials. As used herein, a low-k dielectric material may have a dielectric constant less than that of SiO₂.

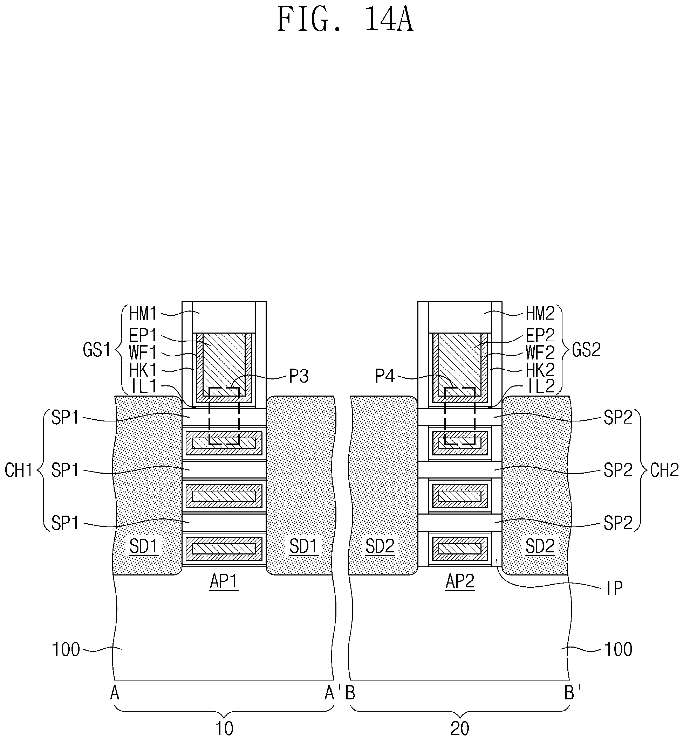

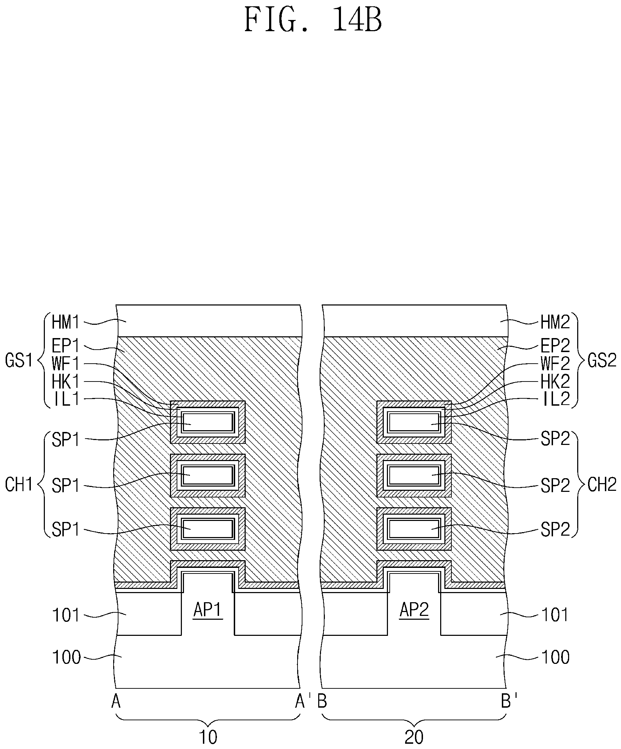

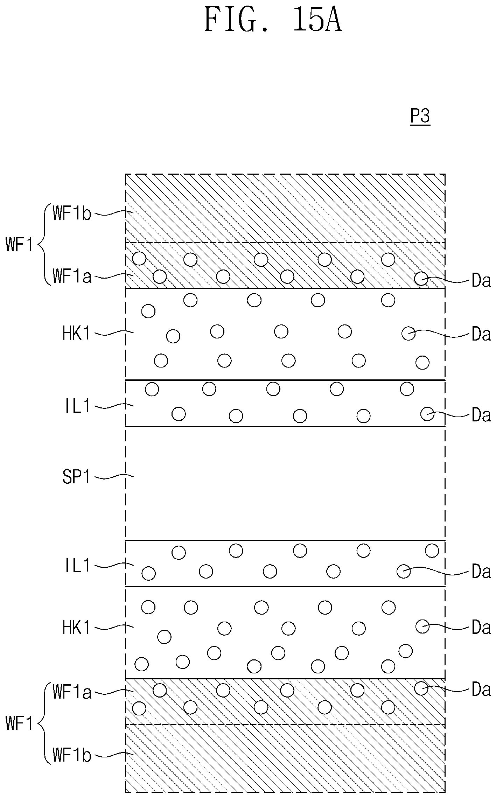

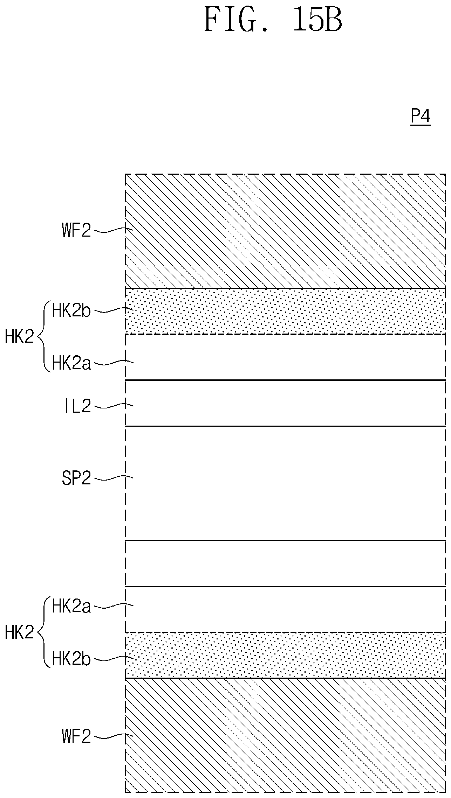

FIG. 14A is a sectional view, which is taken along the lines A-A' and B-B' of FIG. 1 to illustrate a semiconductor device according to various example embodiments. FIG. 14B is a sectional view, which is taken along the lines C-C' and D-D' of FIG. 1 to illustrate a semiconductor device according to various example embodiments. FIG. 15A is an enlarged sectional view illustrating a portion 'P3' of FIG. 14A. FIG. 15B is an enlarged sectional view illustrating a portion 'P4' of FIG. 14A. For concise description, a previously described element may be identified by the same reference number without repeating an overlapping description thereof.

Referring to FIGS. 14A and 14B, the transistors provided on the first and second regions 10 and 20 may be a three-dimensional field effect transistor (e.g., a multi-bridge-channel field effect transistor (MBCFET^{™}) or a gate-all-around field effect transistor (GAAFET)), in which a gate electrode is provided to three-dimensionally surround a nano-wire channel or a nano-sheet channel.

In detail, first and second channel patterns CH1 and CH2 may be disposed on the first and second active patterns AP1 and AP2, respectively. The first channel pattern CH1 may include first semiconductor patterns SP1, which are stacked to be vertically spaced apart from each other, and the second channel pattern CH2 may include second semiconductor patterns SP2, which are stacked to be vertically spaced apart from each other.

The first channel pattern CH1 may be disposed between the first source/drain regions SD1, and the second channel pattern CH2 may be disposed between the second source/drain regions SD2.

The first semiconductor patterns SP1 of the first channel pattern CH1 may have the same thickness or may have different thicknesses from each other. The second semiconductor patterns SP2 of the second channel pattern CH2 may have the same thickness or may have different thicknesses from each other.

The first source/drain regions SD1 may be epitaxial patterns that are formed using the first semiconductor patterns SP1 as a seed layer. The second source/drain regions SD2 may be epitaxial patterns that are formed using the second semiconductor patterns SP2 as a seed layer.

Sidewall insulating patterns IP may be interposed between the second source/drain regions SD2 and the second gate electrodes EP2. The sidewall insulating patterns IP may be interposed between the second semiconductor patterns SP2, which are vertically spaced apart from each other. The sidewall insulating patterns IP may electrically disconnect the first and second gate electrodes EP1 and EP2 from the first and second source/drain patterns SD1 and SD2. In various example embodiments, the sidewall insulating patterns IP may include silicon nitride.

The first and second gate structures GS1 and GS2 may extend in a specific direction to cross the first and second channel patterns CH1 and CH2. The first and second gate structures GS1 and GS2 may be vertically overlapped with the first and second channel patterns CH1 and CH2, respectively. A pair of gate spacers may be respectively disposed on opposite side surfaces of an outer electrode of each of the first and second gate structures GS1 and GS2.

Each of the first and second gate structures GS1 and GS2 may include inner electrodes, which are interposed between the active pattern AP1 or AP2 and the first and second semiconductor patterns SP1 and SP2, and an outer electrode, which are provided on the first and second semiconductor patterns SP1 and SP2.

The first gate structure GS1 may include the first interface pattern IL1, the first high-k dielectric pattern HK1, the first metal pattern WF1, the first gate electrode EP1, and the first hard mask pattern HM1, as described above.

The second gate structure GS2 may include the second interface pattern IL2, the second high-k dielectric pattern HK2, the second metal pattern WF2, the second gate electrode EP2, and the second hard mask pattern HM2, as described above.

In detail, referring to FIGS. 15A and 15, the first and second interface patterns IL1 and IL2 may be respectively interposed between the first and second gate electrodes EP1 and EP2 and the first and second semiconductor patterns SP1 and SP2. The first and second interface patterns IL1 and IL2 may enclose the first and second semiconductor patterns SP1 and SP2. For example, the first interface pattern IL1 may cover a top surface, a bottom surface, and opposite side surfaces of each of the first semiconductor patterns SP1, and the second interface pattern IL2 may cover a top surface, a bottom surface, and opposite side surfaces of each of the second semiconductor patterns SP2. The first and second interface patterns IL1 and IL2 may directly cover the first and second semiconductor patterns SP1 and SP2. The first and second interface patterns IL1 and IL2 may be interposed between the inner electrode and the corresponding active pattern AP1 or AP2. In various example embodiments, the first and second interface patterns IL1 and IL2 may include a silicon oxide layer and/or a silicon oxynitride layer.

The first and second high-k dielectric patterns HK1 and HK2 may enclose the first and second semiconductor patterns SP1 and SP2, respectively, on the first and second interface patterns IL1 and IL2. The first and second high-k dielectric patterns HK1 and HK2 may include at least one of metal oxides. The first and second high-k dielectric patterns HK1 and HK2 may contain the same first metal element and oxygen. The first metal element may include at least one of hafnium, zirconium, tantalum, lanthanum, titanium, barium, strontium, lithium, aluminum, lead, scandium, zinc, niobate.

As described above, the first high-k dielectric pattern HK1 includes the dipole material Da. The second high-k dielectric pattern HK2 need not include the dipole material Da in the first high-k dielectric pattern HK1 and may include a lower portion HK2a and an upper portion HK2b, which are adjacent to the second interface pattern IL2 and the second metal pattern WF2, respectively, where an oxygen content of the upper portion HK2b is higher than an oxygen content of the lower portion HK2a.

The first and second metal patterns WF1 and WF2 may enclose the first and second semiconductor patterns SP1 and SP2, respectively, on the first and second high-k dielectric patterns HK1 and HK2. The first and second metal patterns WF1 and WF2 may include a work-function metal, which is used to adjust the threshold voltage of the transistor. By adjusting thicknesses and compositions of the first and second metal patterns WF1 and WF2, it may be possible to realize a transistor having a desired threshold voltage.

The first and second metal patterns WF1 and WF2 may include a metal nitride layer. For example, the first and second metal patterns WF1 and WF2 may include at least one metallic material, which is selected from among titanium (Ti), tantalum (Ta), aluminum (Al), tungsten (W), and molybdenum (Mo), and nitrogen (N). Furthermore, the first and second metal patterns WF1 and WF2 may further include carbon (C). The first and second metal patterns WF1 and WF2 may include a plurality of work-function metal layers stacked.

In various example embodiments, the first metal pattern WF1 may include the first lower portion WF1a, which is in contact with a top surface of the first high-k dielectric pattern HK1, and the first upper portion WF1b, which is spaced apart from the first high-k dielectric pattern HK1, as described above. The first lower portion WF1a of the first metal pattern WF1 may include a dipole material, which is used to adjust the threshold voltage of the transistor and is the same as the dipole material Da in the first high-k dielectric pattern HK1.

The first and second gate electrodes EP1 and EP2 may enclose the first and second semiconductor patterns SP1 and SP2, respectively, on the first and second metal patterns WF1 and WF2. The first and second gate electrodes EP1 and EP2 may include a metallic material whose resistance is lower than the first and second metal patterns WF1 and WF2. For example, the first and second gate electrodes EP1 and EP2 may include at least one metallic material, which is selected from among tungsten (W), aluminum (Al), titanium (Ti), and tantalum (Ta).

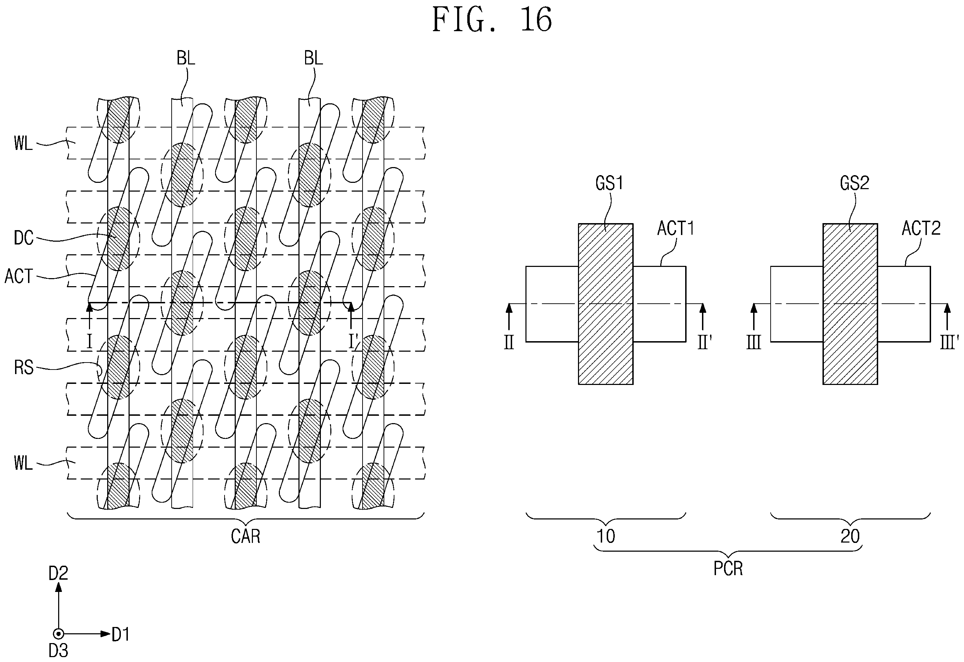

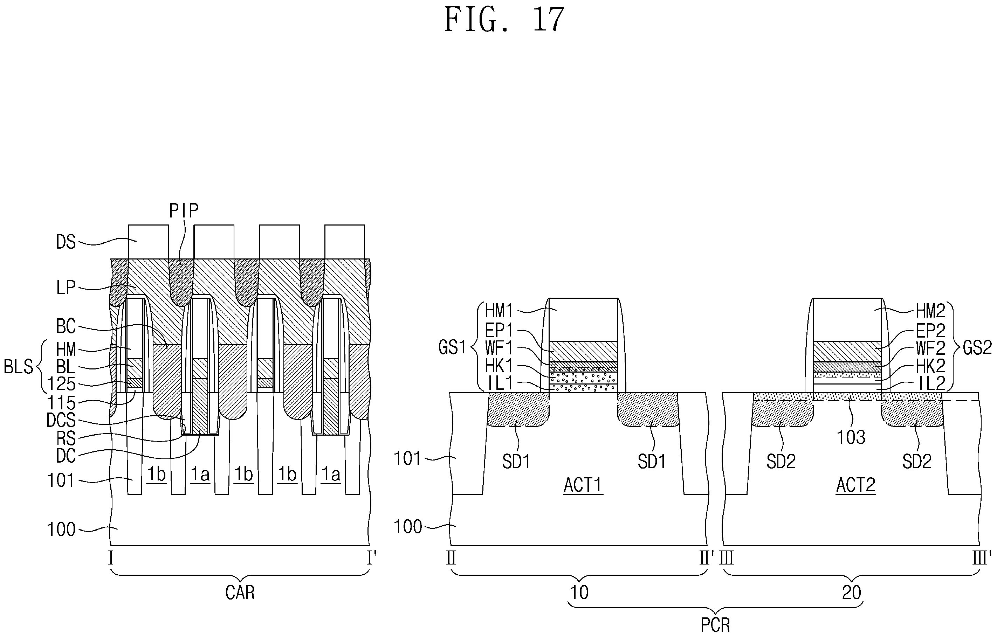

FIG. 16 is a plan view illustrating a semiconductor device according to various example embodiments. FIG. 17 is a sectional view, which is taken along lines I-I', II-II', and III-III' of FIG. 16 to illustrate a semiconductor device according to various example embodiments. For concise description, a previously described element may be identified by the same reference number without repeating an overlapping description thereof.

Referring to FIGS. 16 and 17, the semiconductor substrate 100 may include a cell array region CAR and a peripheral circuit region PCR, and the peripheral circuit region PCR may include a first region 10 and a second region 20.

Peripheral circuits may be disposed on the first and second regions 10 and 20 to drive word lines and bit lines BL, which are provided on the cell array region CAR. In various example embodiments, an NMOS transistor may be provided on the first region 10, and a PMOS transistor may be provided on the second region 20.

In more detail, the device isolation layer 101 may be disposed to define cell active regions ACT in the cell array region CAR of the semiconductor substrate 100. In various example embodiments, the semiconductor substrate 100 may be or include a silicon wafer, a germanium wafer, or a silicon-germanium wafer.

In various example embodiments, when viewed in a plan view, the cell active regions ACT may have a rectangular or bar shape and may be two-dimensionally arranged in a first direction D1 and a second direction D2, which are non-parallel (e.g., perpendicular) to each other. When viewed in a plan view, the cell active regions ACT may be arranged in a zigzag shape and may have a long axis that is not parallel to both of the first and second directions D1 and D2 or is extended in an inclined direction.

Word line structures WL may be provided in the semiconductor substrate 100 and may be extended in the first direction D1 to cross the cell active regions ACT. Each of the word line structures WL may include a word line, a gate insulating pattern between the semiconductor substrate 100 and the word line, and a gate capping pattern on the word line. The word lines may include a conductive material. The gate insulating pattern may include at least one of silicon oxide, silicon nitride, silicon oxynitride, and high-k dielectric materials. The gate capping pattern may include at least one of, for example, silicon nitride or silicon oxynitride.

The word line structures WL may be disposed in the semiconductor substrate 100 and may be extended in the first direction D1 to cross the cell active regions ACT and the device isolation layer 101, when viewed in a plan view. Each of the cell active regions ACT may intersect with a pair of the word line structures WL. Top surfaces of the word lines in the word line structures WL may be located below the top surface of the semiconductor substrate 100. A height of the bottom surface of each word line may vary depending on an underlying material.

First and second impurity regions 1a and 1b may be formed in each of the cell active regions ACT disposed at both sides of the word line structures WL. Bottom surfaces of the first and second impurity regions 1a and 1b may be located at a specific depth from the top surfaces of the cell active regions ACT. The first impurity region 1a may be disposed in each of the cell active regions ACT, between the word line structures WL, and the second impurity regions 1b may be disposed in end portions of each of the cell active regions ACT, which are spaced apart from the first impurity region 1a. The first and second impurity regions 1a and 1b may be doped to have a conductivity type different from the semiconductor substrate 100.

A buffer insulating layer 115 may be provided on the semiconductor substrate 100. In various example embodiments, the buffer insulating layer 115 may be provided to have a single- or multi- layered structure.

Bit line structures BLS may be provided on the semiconductor substrate 100 to cross the word line structures WL and to extend in the second direction D2. Each of the bit line structures BLS may be placed on the first impurity regions 1a. In various example embodiments, the bit line structures BLS may include a polysilicon pattern 125 extending in the second direction D2, a bit line BL on the polysilicon pattern 125, and a hard mask pattern HM on the bit line BL. The buffer insulating layers 115 may be interposed between the polysilicon pattern 125 and the semiconductor substrate 100. A bit line contact pattern DC may be disposed between the bit line BL and the first impurity regions 1a. The bit line contact pattern DC may be in contact with the first impurity regions 1a. The bit line contact pattern DC may include polysilicon, and a silicide pattern may be interposed between the bit line contact pattern DC and the bit line BL. The silicide pattern may include at least one of titanium silicide, cobalt silicide, or nickel silicide. The bit line contact pattern DC may include at least one of conductive metal nitrides (e.g., titanium nitride and/or tantalum nitride) or metallic materials (e.g., one or more of tungsten, titanium, and tantalum).

A bottom surface of the bit line contact pattern DC may be located at a level that is lower than the top surface of the semiconductor substrate 100 and is higher than the top surfaces of the word lines. For example, the bit line contact pattern DC may be locally disposed in a recess region RS, which is formed in the semiconductor substrate 100 to expose the first impurity regions 1a. The recess region RS may have an elliptical shape when viewed in a plan view, and the smallest width of the recess region RS may be larger than a width of each of the bit line structures BLS.

In the bit line structures BLS, the hard mask pattern HM may include an insulating material (e.g., silicon nitride).

A bit line contact spacer DCS may fill a remaining space of the recess region RS, which is partially filled with the bit line contact pattern DC. In various example embodiments, the bit line contact spacer DCS may be provided to cover opposite side surfaces of the bit line contact pattern DC. For example, the bit line contact spacer DCS may include at least one of silicon oxide, silicon nitride, and/or silicon oxynitride and may have a multi-layered structure.

In various example embodiments, bit line spacers may be disposed on opposite side surfaces of the bit line structures BLS. The bit line spacers may be extended along the bit line structures BLS and in the second direction D2. The bit line spacers may be disposed between the side surfaces of the bit line structures BLS and a buried contact pattern BC.

In various example embodiments, the buried contact patterns BC may be disposed between an adjacent pair of the bit line structures BLS. The buried contact patterns BC may include at least one of doped polysilicon or metallic materials. The buried contact patterns BC may be in direct contact with the second impurity regions 1b, respectively. The buried contact patterns BC may be respectively disposed between the word line structures WL and between the bit line structures BLS, when viewed in a plan view.

The buried contact patterns BC may be disposed to be two-dimensionally spaced apart from each other. Top surfaces of the buried contact patterns BC may be located at a level lower than the top surfaces of the bit line structures BLS.

Bottom surfaces of the buried contact patterns BC may be located at a level that is lower than the top surface of the semiconductor substrate 100 and is higher than the bottom surface of the bit line contact pattern DC. In addition, the buried contact patterns BC may be electrically disconnected from the bit line contact pattern DC by the bit line contact spacer DCS.

Fence patterns (not shown) may be disposed between the bit line structures BLS to be spaced apart from each other in the second direction D2. The fence patterns may be disposed between the buried contact patterns BC, which are adjacent to each other in the second direction D2. The fence patterns may overlap with the word lines WL, when viewed in a plan view. The fence patterns may include at least one of insulating materials (e.g., silicon nitride).

Landing pads LP may be disposed on the buried contact patterns BC, respectively. The landing pads LP may be electrically connected to the buried contact patterns BC, respectively.

In various example embodiments, the landing pad LP may include a lower portion, which is formed to fill a space between the bit line structures BLS, and an upper portion, which is extended from the lower portion to face portions of the bit line structures BLS. In other words, the upper portion of the landing pad LP may be overlapped with a portion of the bit line structure BLS, when viewed in a plan view. Each of the upper portions of the landing pads LP may cover the top surface of the hard mask pattern HM of the bit line structure BLS and may have a width larger than the buried contact patterns BC. That is, an upper width of the landing pad LP may be larger than a distance between the bit line structures BLS or a width of the bit line structures BLS. In this case, since the upper portion of the landing pad LP is extended to a region on the bit line structure BLS, the top surface of the landing pad LP may have an increased area.

The top surface of the landing pad LP may be located at a level higher than the top surfaces of the bit line structures BLS, and the bottom surface of the landing pad LP may be located at a level lower than the bottom surfaces of the bit line structures BLS.

In various example embodiments, when viewed in a plan view, the upper portion of the landing pad LP may have an elliptical shape with long and short axes, and here, the long axis of the upper portion of the landing pad LP may be inclined to both of the first and second directions D 1 and D2. In various example embodiments, the upper portion of the landing pad LP may have a rounded diamond shape, a rounded trapezoidal shape, or a rounded tetragonal shape.

A pad insulating pattern PIP may be provided to fill a space between the upper portions of the landing pads LP. The pad insulating pattern PIP may have a rounded bottom surface, and the bottom surface of the pad insulating pattern PIP may be in contact with portions of the bit line spacers. A top surface of the pad insulating pattern PIP may be coplanar with the top surfaces of the landing pads LP. The pad insulating pattern PIP may include a silicon oxide layer, a silicon nitride layer, and/or a silicon oxynitride layer. The pad insulating pattern PIP may be provided to have a single- or multi- layered structure.

In various example embodiments, data storage patterns DS may be disposed on the landing pads LP, respectively. The data storage patterns DS may be electrically connected to the second impurity regions 1b, respectively, through the landing pads LP and the buried contact patterns BC. Each of the data storage patterns DS may be disposed to be offset from a corresponding one of the landing pads LP and may be in contact with a portion of each of the landing pads LP. In various example embodiments, the data storage patterns DS may be arranged to form a honeycomb shape or a zigzag shape, when viewed in a plan view.

In various example embodiments, the data storage pattern DS may be or may include a capacitor, which includes bottom and top electrodes and a dielectric layer therebetween. Alternatively, the data storage pattern DS may be or may include a variable resistance pattern whose resistance can be switched to one of at least two states by an electric pulse applied to a memory element. For example, the data storage pattern DS may include at least one of phase-change materials whose crystal state can be changed depending on an amount of a current applied thereto, perovskite compounds, transition metal oxides, magnetic materials, ferromagnetic materials, or antiferromagnetic materials.

In the peripheral circuit region PCR, a first transistor having a first threshold voltage may be provided on the first region 10, and a second transistor having a second threshold voltage may be provided on the second region 20.

The device isolation layer 101 may define the first active region ACT1 in the first region 10 and the second active region ACT2 in the second region 20.

The first gate structure GS1 may be disposed on the first active region ACT1, and the first source/drain regions SD1 may be provided in the semiconductor substrate 100 disposed at both sides of the first gate structure GS1. The first source/drain regions SD1 may be portions of the semiconductor substrate 100 that are doped with impurities of a first conductivity type (e.g., n-type such as one or more of arsenic or phosphorus).

The second gate structure GS2 may be disposed on the second active region ACT2 and on the semiconductor substrate 100, and the second source/drain regions SD2 may be provided in the semiconductor substrate 100 disposed at both sides of the second gate structure GS2. The second source/drain regions SD2 may be portions of the semiconductor substrate 100 that are doped with impurities of a second conductivity type (e.g., p-type such as but not limited to boron).

As described above, the first gate structure GS1 may include the first interface pattern IL1, the first high-k dielectric pattern HK1, the first metal pattern WF1, the first gate electrode EP1, and the first hard mask pattern HM1, and here, the first high-k dielectric pattern HK1 and the lower portion of the first metal pattern WF1 may include a dipole material, which is used to adjust the threshold voltage of the transistor.

As described above, the second gate structure GS2 may include the second interface pattern IL2, the second high-k dielectric pattern HK2, the second metal pattern WF2, the second gate electrode EP2, and the second hard mask pattern HM2, and here, the second high-k dielectric pattern HK2 may be formed of at least one of metal oxides and may have an oxygen content that is higher in the upper portion thereof than in the lower portion thereof. The upper portion of the second high-k dielectric pattern HK2 having a higher oxygen content may be used to adjust the threshold voltage of the transistor.

The first and second metal patterns WF1 and WF2 of the first and second gate structures GS1 and GS2 may be formed of the same metallic material.

The first and second gate electrodes EP1 and EP2 of the first and second gate structures GS1 and GS2 may include a metallic material whose resistance is lower than the first and second metal patterns WF1 and WF2, and the bit line BL of the bit line structure BLS may include the same metallic material as the first and second gate electrodes EP1 and EP2.

Furthermore, a channel layer 103 may be disposed between the second gate structure GS2 and the semiconductor substrate 100. In other words, the channel layer 103 may be disposed between the second interface pattern IL2 and the semiconductor substrate 100. The channel layer 103 may be formed by a selective epitaxial growth (SEG) process. The channel layer 103 may include a semiconductor material that has a carrier mobility higher than silicon. For example, the channel layer 103 may be a silicon-germanium layer having a lattice constant different from the semiconductor substrate 100. The channel layer 103 may be formed to have a thickness of about 80 Å to 120 Å.

According to various example embodiments, in first and second transistors with different threshold voltages, it may be possible to reduce a height difference between first and second gate structures and to optimize the threshold voltage of the first and second transistors.

Alternatively or additionally according to various example embodiments, first and second metal patterns of the first and second gate structures may be formed of the same metallic material, and a height difference between the first and second gate structures may be reduced.

Alternatively or additionally, a dipole layer may contain a first adjustment material that is used to adjust a threshold voltage of a first transistor on a first region, but the dipole layer may be removed from a second region to prevent or reduce the first adjustment material from entering a high-k dielectric pattern on the second region. Accordingly, it may be possible to prevent or reduce degradation of the characteristics of a second transistor, which is provided on the second region.

While various example embodiments of the inventive concept have been particularly shown and described, it will be understood by one of ordinary skill in the art that variations in form and detail may be made therein without departing from the scope of the attached claims. Furthermore example embodiments are not necessarily mutually exclusive with one another. For example, some example embodiments may include one or more features described with reference to one or more figures, and may also include one or more other features described with reference to one or more other figures.

## Claims

1. A semiconductor device, comprising:
a semiconductor substrate including a first region and a second region;
a first gate structure on the first region of the semiconductor substrate; and
a second gate structure on the second region of the semiconductor substrate,
wherein the first gate structure comprises a first metal pattern, a first high-k dielectric pattern between the semiconductor substrate and the first metal pattern, and a first work-function layer between the first high-k dielectric pattern and the first metal pattern,
the second gate structure comprises a second metal pattern, a second high-k dielectric pattern between the semiconductor substrate and the second metal pattern, and a second work-function layer between the second high-k dielectric pattern and the second metal pattern,
the first work-function layer comprises a first metal element included in the first metal pattern and a dipole material included in the first high-k dielectric pattern,
the second work-function layer and the second high-k dielectric pattern comprise a metal oxide material, and
an oxygen content in the second work-function layer is greater than an oxygen content in the second high-k dielectric pattern.

2. The semiconductor device of claim 1, wherein the first work-function layer and the second work-function layer are at different distances from a top surface of the semiconductor substrate.

3. The semiconductor device of claim 1, or 2, wherein the second high-k dielectric pattern and the second work-function layer are dipole-free.

4. The semiconductor device of claim 1, 2 or 3, wherein the dipole material in the first high-k dielectric pattern (HK1) comprises a lanthanoid material.

5. The semiconductor device of any one of claims 1 to 4, wherein
at least one of the first or second high-k dielectric patterns comprise a second metal element, silicon (Si), and oxygen (O).

6. The semiconductor device of any one of claims 1 to 5, wherein the first high-k dielectric pattern has a thickness equal to the second high-k dielectric pattern.

7. The semiconductor device of any one of claims 1 to 6, wherein the first and second metal patterns comprise a metallic material having a same work-function.

8. The semiconductor device of claim 7, wherein the first metal pattern has a same thickness as the second metal pattern.

9. The semiconductor device of any one of claims 1 to 8, wherein the second work-function layer comprises the first metal element.

10. The semiconductor device of any one of claim 1 to 9, wherein
the first gate structure further comprises a first interface pattern between the semiconductor substrate and the first high-k dielectric pattern,
the second gate structure further comprises a second interface pattern between the semiconductor substrate and the second high-k dielectric pattern, and
the first and second interface patterns comprise a same dielectric material.

11. The semiconductor device of claim 10, wherein the first interface pattern further comprises the dipole material.

12. The semiconductor device of any one of claims 1 to 11, wherein the first work-function layer comprises LaTiN, and the second work-function layer comprises TiHfON.

13. The semiconductor device of any one of claims 1 to 12, further comprising:
a bit line extending in one direction on a cell active region of the semiconductor substrate; and
a bit line contact pattern between the bit line and the cell active region,

14. The semiconductor device of claim 13, wherein
the first gate structure further comprises a first gate electrode on the first metal pattern,
the second gate structure further comprises a second gate electrode on the second metal pattern,
the first gate electrode and the second gate electrode comprise a first metallic material, which is same as that in the bit line, and
both of the first and second metal patterns comprise a second metallic material.

15. The semiconductor device of any one of claims 1 to 14, further comprising:
a channel layer between the second gate structure and the semiconductor substrate,
wherein the channel layer has a lattice constant different from the semiconductor substrate.
